# EUROPÄISCHE PATENTSCHRIFT

(11) **EP 0 568 767 B1**
(45) Veröffentlichungstag und Bekanntmachung des Hinweises auf die Patenterteilung: **01.05.1996**
(21) Anmeldenummer: 93101489.8
(22) Anmeldetag: 30.01.1993
(51) Int. Cl.: H01M 10/48, G01R 31/36

(54) **Verfahren zur Bestimmung des Ladezustandes einer elektrochemischen Zelle**
Method for determining the state of charge of an electrochemical cell
Procédé pour déterminer l'état de charge d'une cellule électrochimique

(30) Priorität: 08.05.1992 DE 4215124
(43) Veröffentlichungstag der Anmeldung: 10.11.1993
(73) Patentinhaber: VARTA Batterie Aktiengesellschaft, D-30405 Hannover (DE)
(72) Erfinder: Meissner, Eberhard, Dr., W-6238 Hofheim 3 (DE); Bräutigam, Reinhard, W-6238 Hofheim 6 (DE)
(74) Vertreter: Kaiser, Dieter Ralf, Dipl.-Ing.

(56) Entgegenhaltungen:
- EP-A- 0 388 099
- US-A- 4 137 374
- JOURNAL OF POWER SOURCES Bd. 7, 1982, LAUSANNE CH Seiten 281 - 291 H.METZENDORF 'The Capacity Limiting Role of the Electronic Conductivity of the Active Material in Lead-Acid Batteries During Discharge'
- INTERNATIONAL TELECOMMUNICATIONS ENERGY CONF. INTELEC '86 Oktober 1986, TORONTO
- CA Seiten 365 - 368 S. DEBARDELABEN 'Determining the End of Battery Life'
- PATENT ABSTRACTS OF JAPAN vol. 5, no. 176 (E-81)(848) 12. November 1981
- PATENT ABSTRACTS OF JAPAN vol. 14, no. 362 (E-960)6. August 1990

## Beschreibung

Die Erfindung betrifft ein Verfahren zur Bestimmung des Ladezustandes einer elektrochemischen Zelle durch Messen der Leitfähigkeit eines der aktiven Zellenbestandteile.

Zur Bestimmung des Ladezustandes von Primär- und Sekundärbatterien sind die verschiedensten Verfahren bekannt. Üblich sind insbesondere Messungen der Batteriespannung oder die Messung der Spannungsantwort der Zelle auf eine Stromveränderung oder aber die Messung der Zellimpedanz.

Diese Verfahren erfordem Eingriffe in den äußeren Stromkreis der Zelle und verändem teilweise ihren Ladezustand. Bei Zellen hoher Kapazität und geringer Impedanz sind hohe Ströme notwendig, um signifikante Meßwerte zu erhalten.

In anderen Fällen geht die Bestimmung des Ladezustandes davon aus, daß sich der Zustand der Zelle in Abhängigkeit vom Umsetzungsgrad der stromliefemden Reaktion ändert. Dabei bieten sich die elektrochemisch aktiven Materialien an, um aus deren Eigenschaftsänderungen im Verlauf der Stromentnahme einen Anhalt für die noch verfügbare Kapazität zu gewinnen.

Sofem der Elektrolyt nicht nur als Transportmedium für die lonenströme fungiert, sondem wie z.B. die Schwefelsäure beim Bleiakkumulator selbst als aktives Material an der elektrochemischen Reaktion beteiligt ist, kann auch aus Änderungen von dessen Leitfähigkeit, Dampfdruck, Dichte, Viskosität, Brechungsindex oder aus Aktivitätsänderungen bestimmter Elektrolytbestandteile auf den Umsetzungsgrad der elektrochemischen Reaktion geschlossen werden.

Viele in der Vergangenheit vorgeschlagene Verfahren zur Anzeige des Ladezustandes von Bleiakkumulatoren gehen daher von Messungen aus, welche Eigenschaftsänderungen der Schwefelsäure zum Gegenstand haben. Bekannt sind u.a. Messungen der Elektrolytfähigkeit, entweder auf direktem Wege oder über den konzentrationsabhängigen Diaphragmenwiderstand einer Ionenaustauschermembran, Konzentrationsmessungen mit Hilfe der Formänderung eines quellbaren Streifens, der aus zwei unterschiedlich in der Lösung quellenden Schichten besteht, Messungen des Wasserdampfpartialdrucks im gaserfüllten Teilraum eines Zellgefäßes oder Messungen der Änderung der spezifischen Dichte der Säure.

Eine Ungenauigkeit haftet den genannten Meßmethoden dadurch an, daß sie Homogenität des Elektrolyten an jedem beliebigen Ort voraussetzen, die in den seltensten Fällen gegeben ist. Dies gilt insbesondere dann, wenn der Elektrolyt in den diversen Porensystemen der Zelle zu einem wesentlichen Teil immobilisiert ist, da dann ein Konzentrationsausgleich nur durch langsame Diffusionsvorgänge erfolgt und einige der vorerwähnten Verfahren gänzlich versagen.

Ein häufig beschrittener Ausweg aus diesem Dilemma führt über die sog. Pilotzelle, die stellvertretend für alle übrigen Zellen im Batterieverbund dazu dient, daß durch laufende Messungen des Stromflusses, der Spannung, der Temperatur etc. auch deren Historie verfolgt wird. Die jeweiligen Meßdaten werden gespeichert und können dann mit Hilfe eines geeigneten Algorithmus in einer Rechenanlage ausgewertet werden. Selbst wenn unterstellt werden darf, daß sich alle Zellen gleichmäßig und wie die Pilotzelle verhalten, ist der Aufwand sehr groß.

Gemäß DE-PS 32 31 363 ist es möglich, mittels eines mit der positiven Elektrode kurzgeschlossenen und mit dem Säureelektrolyt in Kontakt befindlichen Leiterstücks aus Blei oder einer Bleilegierung einen Hinweis auf die bevorstehende Kapazitätserschöpfung zu erhalten, indem sich der elektrische Widerstand des Leiterstücks durch Korrosion gegen Ende der Akkumulator-Lebensdauer sprunghaft ändert und die Widerstandsänderung in ein elektrisches oder optisches Signal umgesetzt wird. Eine Aussage darüber, wieviel Energie tatsächlich momentan verfügbar ist, kann diese Meßmethode jedoch nicht liefern.

Aus der JP-A-56 103 875 ist es bekannt, bei einer Bleiplatte die Eigenleitfähigkeit der Aktivmasse zu messen, indem eine aus dieser Masse bestehende Schicht zwischen zwei Hilfselektroden eingegrenzt wird und zwei Potentialsonden in dem Aktivmaterial eine Meßstrecke abgreifen. Aus Veränderungen der Masseschicht soll die Lebenserwartung der Batterie abgeschätzt werden können.

Schließlich wird in der JP-A-2 129 866 für eine Zink/Brom-Batterie eine Meßanordnung beschrieben, welche den bevorstehenden Entladeschluß der Batterie durch ein elektrisches Signal ankündigt, wobei dieses durch rapide Potential- bzw. Leitfähigkeitsänderungen der Zinkelektrode kurz vor deren Erschöpfung ausgelöst wird.

Der Erfindung liegt die Aufgabe zugrunde, ein Verfahren zur Bestimmung des Ladezustandes von elektrochemischen Zellen anzugeben, bei dem die Meßergebnisse eine zuverlässige Übersicht über den momentan noch verfügbaren Ladungsinhalt der Zelle erlauben, sowohl bei frei beweglichen wie bei immobilisierten Elektrolyten.

Die Aufgabe wird erfindungsgemäß durch ein Verfahren gelöst, wie es durch den Patentanspruch 1 definiert ist.

Erfindungsgemäß wird die Elektrode als Ganzes, also zusammen mit ihrem Stromableitergerüst, in den Meßvorgang mit einbezogen. Eine günstige Voraussetzung für diesen Fall ist immer dann gegeben, wenn die Messung der Eigenleitfähigkeit des aktiven Materials nicht zu stark von der Eigenleitfähigkeit der im allgemeinen metallisch leitenden Ableiterstruktur dominiert wird, mit anderen Worten: wenn die in einer Elektrode vereinigten spezifischen Leitfähigkeiten von aktiver Masse und Ableitermaterial sich nicht allzu stark unterscheiden.

Erfindungsgemäß wird die Elektrode mit einem Wechselstrom aus einer externen Stromversorgungsquelle belastet. Als Antwort auf die Belastung ist längs einer Meßstrecke ein Spannungsabfall meßbar, welcher ein Maß für die Leitfähigkei darstellt.

An sich ist es bekannt, sowohl das aktive Material als auch den inaktiven Masseträger einer Elektrode einer Leitfähigkeitsmessung in situ zu unterwerfen. Nach W.Borger, U.Hullmeine, H.Laig-Hörstebrock und E.Meissner (siehe bei T.Keily, W.Baxter (ed.), Power Sources 12 (1989) S.131-145) gelingt es mittels Sonden aus Platindraht, den Widerstand des im Massefeld einer arbeitenden positiven Gitterplatte eingeschlossenen PbO₂ messend zu verfolgen.

Anhand eines Beispiels und von Figuren wird im folgenden die Technik des erfindungsgemäßen Verfahrens vorgestellt und die Aussage der Messungen erläutert.

Figur 1 zeigt eine Elektrode mit angedeuteten Stellen zum Abgreifen einer Meßspannung.

Figur 2 zeigt den Schaltungsaufbau einer Anordnung zur Durchführung des erfindungsgemäßen Meßverfahrens.

Die Figuren 3 bis 6 zeigen Meßkurven für eine negative Pb/PbSO₄-Elektrode.

### Beispiel: Negative Pb/PbSO₄-Elektrode

Die spezifische Leitfähigkeit von geladener negativer Pb-Masse, so wie sie in Bleiakkumulatoren zur Anwedung kommt, wird mit ca. 5000 Ω⁻¹cm⁻¹ angegeben (H.Metzendorf, Joumal Power Sources 7 (1982) S. 281-291), die des üblicherweise als Ableitermaterial verwendeten metallischen Bleis mit ca. 48000 Ω⁻¹cm⁻¹ (D'Ans-Lax). Dennoch ändert sich der Elektrodenwiderstand signifikant mit dem Entladegrad der Elektrode.

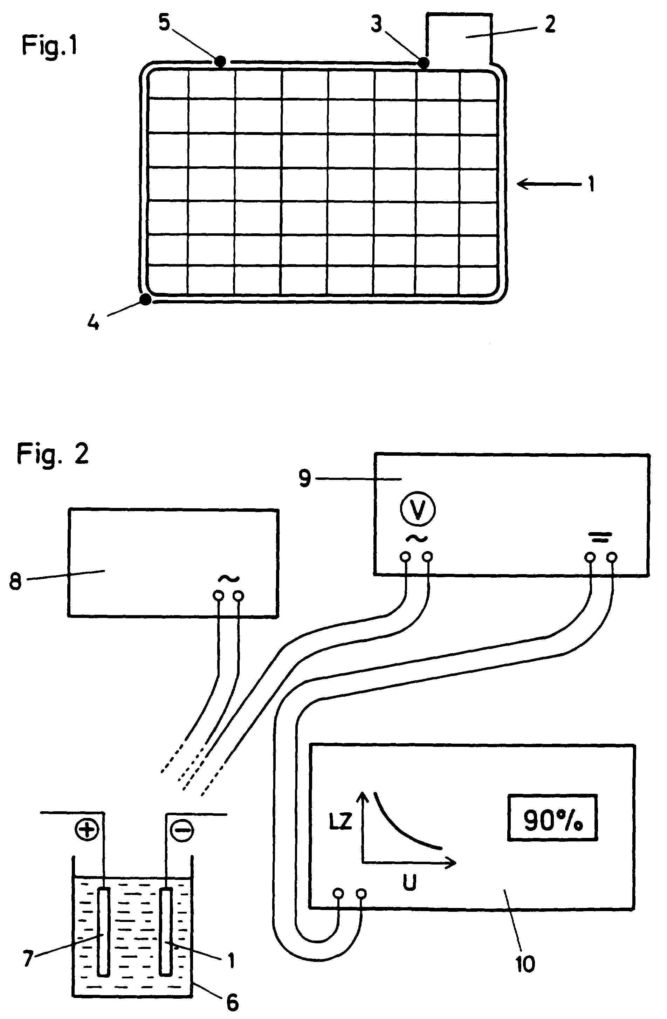

An einer beispielhaft in Figur 1 dargestellten negativen Elektrode 1, wie sie in Starterakkumulatoren verwendet wird, werden zusätzlich zu einem Abgriff 3 an der Ableiterfahne 2 je ein weiterer Abgriff 4 an der der Fahne diagonal gegenüberliegenden Ecke sowie ein Abgriff 5 an der Oberseite der Elektrode angebracht.

In der Meßanordnung gemäß Figur 2 ist die negative Elektrode 1 von Figur 1 zusammen mit einer positiven Gegenelektrode 7 Bestandteil der elektrochemischen Zelle 6, die als Elektrolyt verdünnte Schwefelsäure enthält.

Die Meßanordnung umfaßt weiterhin:
- eine Wechselstromquelle 8, die einen sinusförmigen Wechselstrom von 1kHz und einer Stromstärke von 100 mA_{eff} erzeugt,
- ein Meßgerät 9 zur Messung einer Wechselspannung der Frequenz 1kHz. Vorteilhaft ist hier ein geeignetes Frequenzfilter oder eine lock-in-Schaltung (phase-locked-loop, PLL, Phasenregelkreis) zur Wechselstromquelle 8, die eine der gemessenen Wechselspannung proportionale Gleichspannung abgibt.
- eine Anzeigeeinheit 10, die mit dem Meßgerät 9 verbunden ist und die auf einem analogen oder digitalen Display den Ladezustand anzeigt.

Es wurde nämlich gefunden, daß ein proportionaler Zusammenhang besteht zwischen dem Widerstand der zu untersuchenden Elektrode 1 und ihrem Ladezustand, wobei der Widerstand, sofern die Elektrode mit einem konstanten Wechselstrom beaufschlagt wird, der zwischen zwei Punkten der Elektrode gemessenen Wechselspannung direkt proportional ist.

Dieser Zusammenhang ergibt sich aus dem praktischen Versuch wie folgt: an der zu untersuchenden Elektrode 1 der elektrochemischen Zelle 6 (hier ein Bleiakkumulator) werden an den weiter vom beschriebenen Stellen 3 und 4 oder 3 und 5 elektrisch leitende Abgriffe angebracht, die mit dem Ableitergitter verbunden sind. Diese Abgriffe bestehen beispielsweise aus Bleidrähten, die durch eine geeignete isolierende und elektrolytdichte Ummantelung gegen Elektrolytzugriff geschützt sind und die aus dem Zellengefäß herausführen.

An den Anschlüssen 2 (Fahne) und 4 der Elektrode wird die Wechselstromquelle 8 und an den Anschlüssen 3 und 5 das Wechselspannungsmeßgerät 9 angeschlossen.

Von der Fahne 2 zu Abgriff 4 wird nun ein sinusförmiger Wechselstrom der Frequenz 1kHz geleitet. Gleichzeitig wird die Wechselspannung zwischen den Abgriffen 3 und 4 oder 3 und 5 gemessen. Die Elektrode wird dann unter Fortsetzung der Spannungsmessungen entladen. Dabei kann die Anzeigeeinheit 10 so eingerichtet sein, daß sie die Wechselstromquelle 8 ansteuert, so daß letztere nicht permanent, sondem nur in Intervallen arbeitet und die während dieser kurzen Zeitabschnitte vom Wechselspannungsmeßgerät 9 empfangenen Spannungsinformationen in der Anzeigeeinheit verarbeitet werden. Diese Ausführung ist besonders stromsparend und dann vorteilhaft, wenn die gesamte Anordnung allein mit dem Strom der zu überwachenden Batterie versorgt werden soll. In jedem Fall muß jedoch auf eine zuverlässige galvanische Entkoppelung zwischen der Batteriespannung und den mit der Elektrode verbundenen Abgriffen geachtet werden.

Es liegt auch im Rahmen der Erfindung, die Wechselstromquelle 8 und das Wechselspannungsmeßgerät 9 durch eine übliche Schaltung zur Messung des Wechselstromwiderstandes nach der 4-Punkt-Methode zu ersetzen. Das so gewonnene Signal ist dem Wechselstromwiderstand proportional und wird entsprechend wie oben von der Anzeigeeinheit 10 verarbeitet.

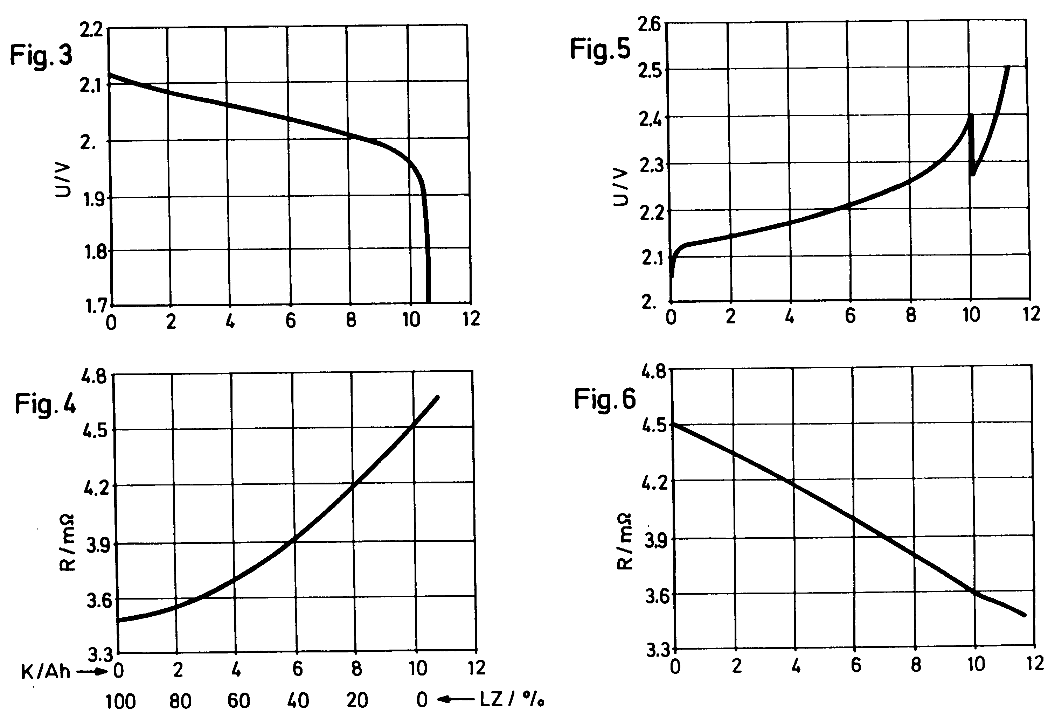

Werden nunmehr die im Laufe der Entladung (zum Spannungsverlauf der Zelle vergleiche Figur 3) erhaltenen Meßwerte, ausgedrückt durch den Quotienten R [mΩ] aus gemessener Wechselspannung und eingebrachtem Wechselstrom, gegen die entnommene Ladungsmenge K[Ah] aufgetragen, ergibt sich die in Figur 4 wiedergegebene Kurve. Ihr entnimmt man, daß die Meßwerte mit zunehmender Entladedauer ansteigen und insgesamt sich um mehrere 10% ändem.

Wegen der direkten Proportionalität von R und Wechselspannung U bei konstant gehaltenem Wechselstrom I bildet U ein unmittelbares Maß für den Ladezustand LZ[%]. Die auf der Anzeigeeinheit 10 in Figur 2 angedeutete Analoganzeige LZ/U macht von diesem Sachverhalt Gebrauch. Daneben ist aber auch eine digitale Anzeige, z.B. LZ=90%, möglich.

Wird die Elektrode anschließend geladen und werden wiederum die Quotienten aus abgegriffener Spannung und Strom gebildet, so erhält man die in den Figuren 5 und 6 wiedergegebenen Kurven. Wie man erkennt, erreicht der Quotient R nach abgeschlossener Volladung den gleichen Wert, der vor Beginn der Entladung gemessen wurde.

Das neue Verfahren macht es also möglich, den Ladezustand der Elektrode einer elektrochemischen Zelle dadurch zu bestimmen, daß der Potentialunterschied zwischen zwei Bereichen der Elektrode in situ während der Beaufschlagung der Elektrode mit einem Lade- oder Entladestrom gemessen wird und daß der aktuelle Ladezustand anhand einer Eichkurve, die auf korrespondierenden Werten des jeweiligen Ladezustandes und der Meßspannung U (oder des Quotienten R=gemessene Wechselspannung/eingebrachter Wechselstrom) beruht, ermittelt wird. Die Messung der Spannung bzw. des Widerstandes kann dabei auch in mehreren Bereichen einer Elektrode, wahlweise auch an mehreren parallel geschalteten Elektroden einer Speicherzelle, zugleich an Elektroden beider Polaritäten und schließlich in gleicher Weise in mehreren durch Parallel- oder Serienschaltung zu einer Batterie verbundenen Speicherzellen vorgenommen werden.

Die simultanen Aufzeichnungen der verschiedenen Meßwerte erfordem zwar einen größeren meßtechnischen Aufwand, ändern jedoch nichts am Prinzip der erfindungsgemäßen Meßmethode. Es bleibt auch im Rahmen der Erfindung, wenn die verschiedenen Messungen nacheinander erfolgen, was mit Hilfe einer einzigen Meßapparatur möglich ist, welche über einen geeigneten Multiplexer mit den Meßojekten nacheinander verbunden wird.

Die aus verschiedenen Bereichen einer Elektrode oder mehreren Elektroden erhaltenen Meßwerte erlauben Rückschlüsse auf die Homogenität des Ladezustandes und machen die Aussage über die Energie, die in der Anordnung gespeichert ist, noch sicherer.

Die für die Energieversorgung der Meßanordnung zu verwendende externe Wechselstromquelle ist für einen Frequenzbereich von 0,01Hz bis 1MHz, vorzugweise 100Hz bis 10kHz ausgelegt. Die Kurvenform des Wechselstromes kann symmetrische oder unsymmetrische, sinusförmige, rechteckige oder sägezahnförmige Gestalt haben. Vorzugweise ist sie jedoch symmetrisch und sinusförmig.

Da fast alle in elektrochemischen Speicherzellen verwendeten Elektrodenmaterialien ihre Leitfähigkeit in Abhängigkeit vom Grad ihrer Umsetzung ändem, ist das erfindungsgemäße Verfahren im Grunde auf alle Fälle anwendbar, bei denen diese Leitfähigkeitsänderung des Elektrodenmaterials im anwendungstechnisch interessanten Bereich der elektrochemischen Umsetzung meßtechnisch erfaßt werden kann.

Die Erfindung läßt sich unter diesen Umständen nicht nur nutzen bei den Elektroden des Bleiakkumulators, sondern auch bei den Elektroden des Nickel/Cadmium-Akkumulators, bei den Elektroden anderer alkalischer Systeme wie Zn/AgO, Zn/HgO, Zn/MnO₂, bei Wasserstoff speichemden Elektroden, bei Lithiumelektroden und schließlich bei Elektroden, die befähigt sind, Lithium und andere Alkalimetalle zu intercalieren. Sie betrifft also sowohl primäre wie sekundäre elektrochemische Zellen.

## Patentansprüche

1. Verfahren zur kontinuierlichen Bestimmung des Ladezustandes einer elektrochemischen Zelle durch Messen der Leitfähigkeit eines der aktiven Zellenbestandteile, dadurch gekennzeichnet, daß eine Elektrode (1) in situ mit einem Wechselstrom aus einer externen Stromversorgungsquelle (8) beaufschlagt wird, daß zwischen zwei, die Elektrode als Ganzes mitsamt ihrem Stromableitergerüst einbeziehenden Punkten (3,4; 3,5), die resultierende Wechselspannung abgegriffen wird und daß aus dem Meßwert der Wechselspannung, welcher bei konstantem Betrag des Wechselstromes dem Widerstand direkt proportional ist, auf den Ladezustand der Zelle geschlossen wird.

2. Verfahren nach Anspruch 1, dadurch gekennzeichnet, daß die Elektrode die negative Platte eines Bleiakkumulators ist.

3. Verfahren nach Anspruch 1, dadurch gekennzeichnet, daß die Elektrode die negative Elektrode eines Ni/Cd-Akkumulators ist.

4. Verfahren nach einem der Ansprüche 1 bis 3, dadurch gekennzeichnet, daß die Elektrode mit einem Wechselstrom des Frequenzbereiches 0,01Hz bis 1MHz, vorzugsweise einer Frequenz zwischen 100Hz und 10kHz, beaufschlagt wird.

5. Verfahren nach einem der Ansprüche 1 bis 4, dadurch gekennzeichent, daß die Wechselspannung zwischen mehreren Punkten einer Elektrode gemessen wird.

6. Verfahren nach einem der Ansprüche 1 bis 4, dadruch gekennzeichnet, daß die Wechselspannung zwischen Punkten mehrerer parallel geschalteter Elektroden und/oder an Elektroden beider Polaritäten einer Speicherzelle gemessen wird.

7. Verfahren nach einem der Ansprüche 1 bis 4, dadurch gekennzeichnet, daß die Wechselspannung zwischen Punkten mehrerer parallel und/oder in Serie geschalteter Elektroden aus mehreren Speicherzellen, welche durch Parallel- und/oder Serienschaltung in einem Batterieverbund stehen, gemessen wird.

8. Verfahren nach einem der Ansprüche 1 bis 7, dadurch gekennzeichnet, daß die verschiedenen Messungen nacheinander erfolgen, indem die Meßapparatur über einen Multiplexer mit den Meßobjekten nacheinander verbunden wird.

## Claims

1. A method for continuous determination of the state of charge of an electrochemical cell by measuring the conductivity of one of the active cell constituents, characterised in that an alternating current from an external power supply source (8) is applied to an electrode (1) in situ, that the resulting alternating current voltage is read off between two points (3, 4; 3, 5) encompassing - the entire electrode together with its current collector frame and that the state of charge of the cell is determined from the measured value for the alternating current voltage, which at a constant alternating current is directly proportional to the resistance.

2. A method as claimed in claim 1, characterised in that the electrode is the negative plate of a lead storage battery.

3. A method as claimed in claim 1, characterised in that the electrode is the negative electrode of a Ni/Cd storage battery.

4. A method as claimed in one of claims 1 to 3, characterised in that an alternating current of frequency range 0.01Hz to 1MHz, preferably a frequency between 100Hz and 10kHz is applied to the electrode.

5. A method as claimed in one of claims 1 to 4, characterised in that the alternating current voltage is measured between a plurality of points of an electrode.

6. A method as claimed in one of claims 1 to 4, characterised in that the alternating current voltage is measured between points of a plurality of electrodes connected in parallel and/or on electrodes of both polarities of a storage cell.

7. A method as claimed in one of claims 1 to 4, characterised in that the alternating current voltage is measured between points of a plurality of electrodes, connected in parallel and/or in series, from a plurality of storage cells which are connected to a battery by parallel and/or series connection.

8. A method as claimed in one of claims 1 to 7, characterised in that the various measurements are performed in succession by connecting the measuring apparatus to the measuring objects in succession by way of a multiplexer.

## Revendications

1. Procédé pour déterminer de façon continue l'état de charge d'une cellule électrochimique en mesurant la conductibilité de l'un des composants actifs de la cellule, procédé caractérisé en ce qu'une électrode (1) est alimentée in situ par un courant alternatif à partir d'une source extérieure d'alimentation de courant (8), en ce qu'entre deux points (3,4 ; 3,5) incluant l'électrode en entier y compris avec ses équipements d'évacuation du courant, on prélève la tension alternative résultante, et en ce qu'à partir de la valeur mesurée de la tension alternative, qui est directement proportionnelle à la résistance, quand le montant du courant alternatif est constant, on déduit l'état de charge de la cellule.

2. Procédé selon la revendication 1, caractérisé en ce que l'électrode est la plaque négative d'un accumulateur au plomb.

3. Procédé selon la revendication 1, caractérisé en ce que l'électrode est l'électrode négative d'un accumulateur nickel/cadmium.

4. Procédé selon l'une des revendications 1 à 3, caractérisé en ce que l'électrode est alimentée par un courant alternatif dans la gamme de fréquences de 0,01 Hz à 1 MHz, de préférence à une fréquence comprise entre 100 Hz et 10 kHz.

5. Procédé selon l'une des revendications 1 à 4, caractérisé en ce que la tension alternative est mesurée entre plusieurs points d'une électrode.

6. Procédé selon l'une des revendications 1 à 4, caractérisé en ce que la tension alternative est mesurée entre des points de plusieurs électrodes montées en parallèle et/ou sur des électrodes des deux polarités d'un élément d'accumulateur.

7. Procédé selon l'une des revendications 1 à 4, caractérisé en ce que la tension alternative est mesurée entre des points de plusieurs électrodes montées en parallèle et/ou en série, à partir de plusieurs éléments d'accumulateurs qui se trouvent en liaison dans une batterie, par un montage en parallèle et/ou en série.

8. Procédé selon l'une des revendications 1 à 7, caractérisé en ce que les différentes mesures se suivent les unes les autres, l'appareil de mesure étant relié, par l'intermédiaire d'un multiplexeur, aux objets à mesurer les uns après les autres.
